# EUROPEAN PATENT APPLICATION

(11) **EP 1 482 622 A2**
(43) Date of publication of application: **01.12.2004**
(21) Application number: 04012946.2
(22) Date of filing: 01.06.2004
(51) Int. Cl.: H02K 11/04, H02K 9/06

(54) **Alternator for motor vehicle**

(30) Priority: 30.05.2003 JP 2003154359
(71) Applicant: Hitachi, Ltd., Chiyoda-ku, Tokyo 101-8010 (JP)
(72) Inventor: Okamura, Masaki, c/o Hitachi Ltd., Chiyoda-ku Tokyo 100-8220 (JP); Atarashi, Takayuki, c/o Hitachi Ltd., Chiyoda-ku Tokyo 100-8220 (JP); Inaba, Toru, c/o Hitachi Ltd., Chiyoda-ku Tokyo 100-8220 (JP); Ishikawa, Toshio, c/o Hitachi Ltd., Chiyoda-ku Tokyo 100-8220 (JP); Ishida, Sakae, c/o Hitachi Ltd., Chiyoda-ku Tokyo 100-8220 (JP)
(74) Representative: Beetz & Partner Patentanwälte

(57) **Abstract**

The invention relates to an alternator for motor vehicle that can effectively cool down the rectifier, taking into account the cooling air flow, and accordingly produces higher output. The alternator for motor vehicle comprises stator (3), rotor (4) installed inside the stator (3) allowing for a rotation clearance, and rectifier (5), installed in the cooling air flow introduced from the outside into the inside, for rectifying the power produced in the stator (3); wherein the rectifier (5) is made of heat sink (29) equipped with positive diodes (28) and heat sink (31) equipped with negative diodes (30) respectively, stacked one over the other, and both diodes (28 and 30) are connected electrically; the heat sinks (29 and 31) are provided with multiple through cooling air openings (37 and 39) around the corresponding diodes (28 and 30) respectively; and the heat sink (29) is provided with heat sinks (35) projected from the mounting surface (29a) of the diodes (28) towards the cooling air inlet side, surrounding the corresponding diodes (28 and 30).

## Description

### CLAIM OF PRIORITY

The present application claims priority from Japanese application serial no. JP2003-154359, filed on May. 30, 2003) , the content of which is hereby incorporated by reference into this application.

### FIELD OF THE INVENTION

The present invention relates to an alternator for motor vehicle, particularly to an alternator equipped with air-cooled rectifier.

### BACKGROUND OF THE INVENTION

Of late, alternator for motor vehicle is required to have higher output because the electric load has increased as the equipment installed on a motor vehicle has diversified. In order to meet this requirement, it becomes necessary to improve the cooling performance of heat generating portion, for example, rectifier comprising diodes. There have been proposed a number of techniques with regard to the improvement of the cooling performance of a rectifier like the above, including a technique where the rectifier is consisted of a positive cooling member and a negative cooling member with an insulation between them and the positive cooling member located outside is provided with cooling air openings for introducing the cooling air into the rectifier (refer to the Patent Document 1, for example).

Japanese Application Patent Pre-publication 2001-511999

### SUMMARY OF THE INVENTION

According to the technique disclosed in the above Patent Document 1, however, printed circuit boards and others are installed closely in the upstream of the cooling air flow for the diodes, which are heat generating members, as if interrupting the cooling air. In a conventional alternator for motor vehicle, since sufficient flow path space for introducing cooling air is not secured near the heat generating members, including diodes, as explained above and the cooling air does not always function effectively to cool down the heat generating members, there is a limitation to the improvement of the cooling performance.

An object of the present invention is to offer an alternator for motor vehicle that can effectively cool down the heat generating members including diodes, taking into account the cooling air flow, and accordingly produce higher output.

In order to achieve the above object, with the present invention, there can be provided two heat sinks. One or both heat sinks can be equipped with positive diodes and/or negative diodes respectively. The heat sinks can be stacked one over the other. One or both heat sinks can be provided with multiple cooling air openings around the corresponding diodes for allowing the cooling air to pass through. The heat sink installed at the inlet side of the cooling air can be provided with portions projected from the mounting surface of the diodes towards the cooling air inlet side, surrounding the corresponding diodes.

### BRIEF DESCRIPTION OF THE DRAWINGS

Fig. 1 is cross-sectional view of the overall construction of the alternator for motor vehicle according to the embodiment of the present invention.
Fig. 2 is plan view of the rear of the alternator for motor vehicle 1, viewing from the right in Fig. 1.
Fig. 3 is cross-sectional view of C-C in Fig. 2.
Fig. 4 is cross-sectional view of D-D in Fig. 2.
Fig. 5 is oblique view of the neighborhood of rectifier.
Fig. 6 is exploded view the neighborhood of rectifier.

### DESCRIPTION OF THE PREFERRED EMBODIMENTS

An embodiment of the alternator for motor vehicle according to the present invention is described hereunder, using figures.

The alternator for motor vehicle according to this embodiment is a so-called Randell type alternator for motor vehicle, where a rotor, receiving exciting current to its exciting winding, is rotated by the rotation drive force transmitted from the internal combustion engine of a motor vehicle (engine of automobile) and the alternating current power generated in a stator winding as a result of the above is rectified by a rectifier so as to obtain direct current power as drive power and battery storage power for the electric devices installed on the vehicle. The alternator for motor vehicle according to this embodiment is so designed to cool the heat generating members including rectifier and stator by circulating the cooling air inside the alternator.

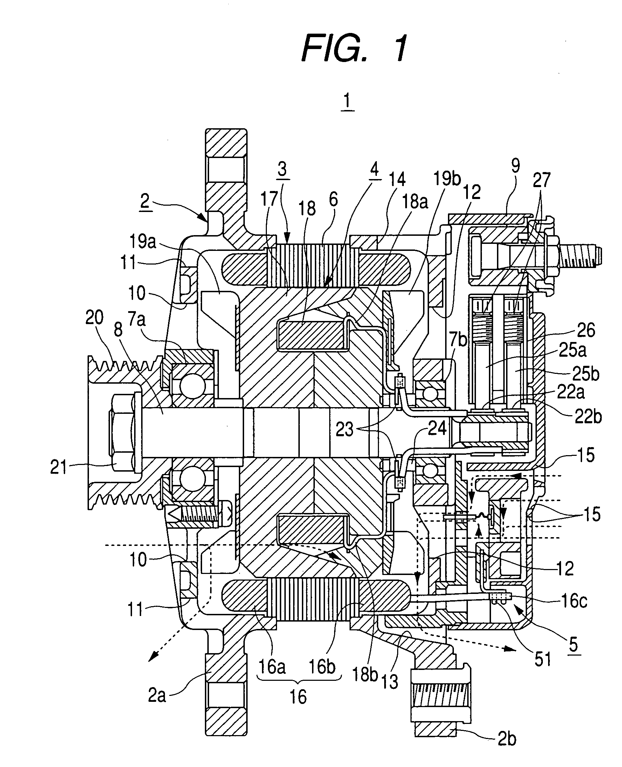

Fig. 1 is a cross-sectional view of the overall construction of the alternator for motor vehicle according to the embodiment of the present invention. In the description hereunder, the horizontal direction in Fig. 1 is called "axial direction" and the positions in the right and left in Fig. 1 are called "front and rear" or "one and the other", respectively as needed.

In Fig. 1, the alternator for motor vehicle 1 of this embodiment basically comprises casing 2 forming the structure of generator body, stator 3 fixed on the inside of the casing 2, rotor 4 installed inside the stator 3 allowing for a rotation clearance, and rectifier 5, installed in the flow of the cooling air introduced from the outside of the alternator to the inside, for rectifying the alternating current power obtained in the stator 3 to direct current power.

The casing 2 consists of front casing 2a and rear casing 2b that is located in the rear opposed to the front casing 2a. The front casing 2a and rear casing 2b together form an annular shape with stator lamination 6 of the stator 3 between them and fastened with bolts (not shown).

Ball bearing 7a and 7b is connected to the inside periphery of the front casing 2a and rear casing 2b, respectively at around the center and shaft (rotation shaft) 8 of the rotor 2 is supported for free rotation by the ball bearings 7a and 7b. Cover (rear cover) 9 for protecting the rectifier 5 and other components is attached to the axial-direction rear end of the rear casing 2b and fastened with bolts (not shown).

Suction ports 10 for the cooling air are provided on the front end of the front casing 2a so as to surround the outside of the connected ball bearing 7a, and exhaust ports 11 are provided along the periphery (outside periphery) of the front casing 2a so as to be located outside the inlet ports 10. On the other hand, cooling air openings 12 are provided on the rear end of the rear casing 2b so as to surround the outside of the connected ball bearing 7b, and cutouts are provide along the periphery (outside periphery) of the rear casing 2b so as to be located outside the cooling air openings 12, the cutouts serving as exhaust ports 13 and 14. In addition, multiple exhaust ports 15 are provided on the rear end of the cover 9.

The stator 3 comprises the stator lamination 6 and the stator winding 16 coiled in a slot (not shown) of the stator lamination 6, and coil ends 16a and 16b of the stator winding 16 located in the front and rear of the stator lamination respectively face with the outside periphery of the rotor 4 allowing for a clearance.

The rotor 4 comprises shaft 8, claw-pole rotors 17 and exciting winding 18 coiled inside the claw of each claw-pole rotor 17. In addition, fans 19a and 19b are installed on the front and rear ends of the rotor 4 respectively for generating the cooling air flow that circulates inside the alternator for motor vehicle 1.

One end of the shaft 8 projects out of the front casing 2a through the ball bearing 7a, and pulley 20 is fastened with nut 21 to the tip. A belt is stretched as a drive power transmission means between the pulley 20 and a pulley installed on the output shaft of the engine of the automobile, all of which are not shown in the figure. The other end of the shaft 8 projects inside the cover 9 through the ball bearing 7b and slip rings 22a and 22b made of electrically conductive annular members are attached to the tip.

The coil ends 18a and 18b of the aforementioned exciting winding 18 are connected to the slip rings 22a and 22b respectively via the connection terminals 23 mounted on the terminal sleeve 24 and also brushes 25a and 25b are in contact with them respectively. The brushes 25a and 25b are supported by the brush holder 26 installed inside the cover 9. Springs 27 are installed inside the brush holder 26 and press the brushes 25a and 25b so as to be in contact with and slip on the rotating slip rings 22a and 22b respectively. With this construction, battery current from a battery (not shown) is supplied as exciting power to the exciting winding 18 by way of the brushes 25a and 25b, slip rings 22a and 22b and connection terminals 23.

On the rear of the rear casing 2b, the rectifier 5 and regulator (voltage regulator, not shown) are installed together with the slip rings 22a and 22b and brushes 25a and 25b, being protected by the cover 9. The rectifier 5 rectifies by full-wave the three-phase alternating current outputted from the stator winding 16 and produces direct current output. In accordance with the power requirement from the vehicle, the regulator controls the exciting current running in the exciting winding 18 via the brushes 25a and 25b and adjusts the three-phase alternating current power outputted from the stator winding 16.

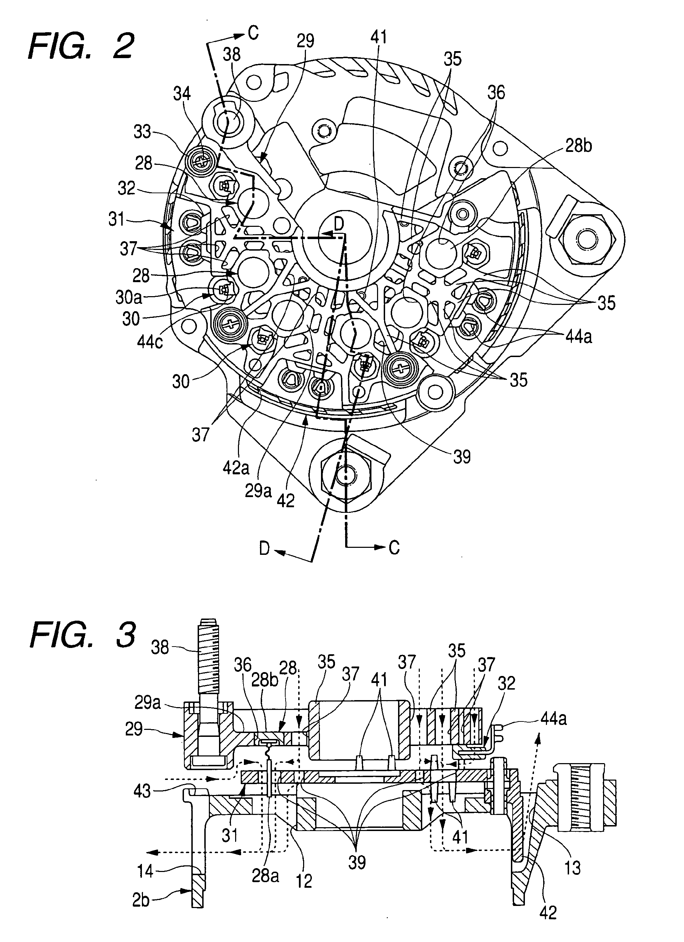

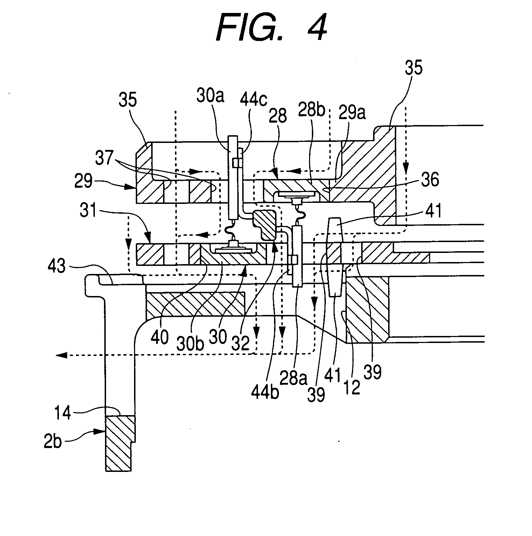

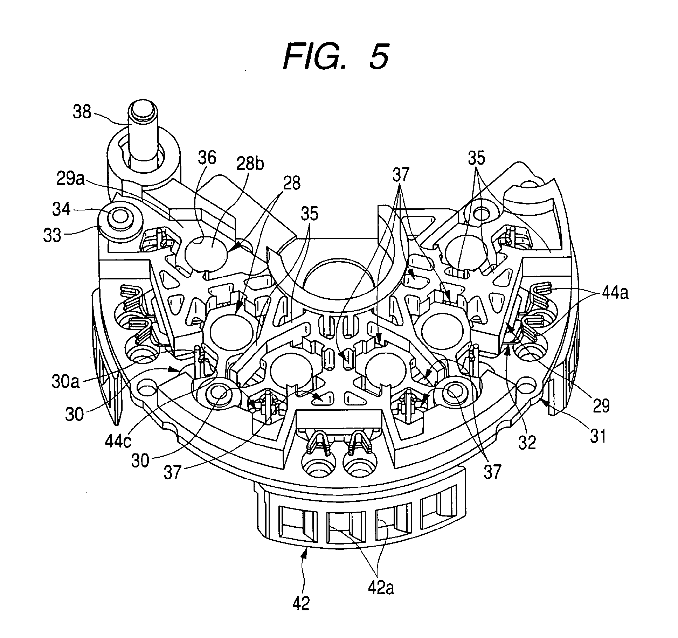

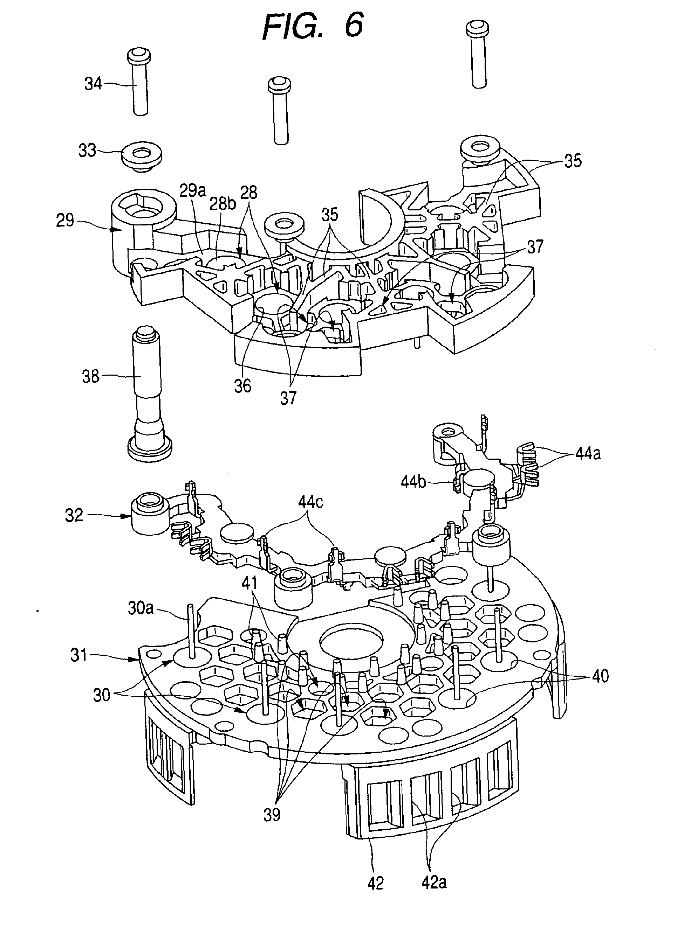

Fig. 2 is a plan view of the rear of the alternator for motor vehicle 1, viewing from the right in Fig. 1; Fig. 3 is a cross-sectional view of C-C in Fig. 2, showing the detailed construction near the rectifier 5; Fig. 4 is a cross-sectional view of D-D in Fig. 2; Fig. 5 is an oblique view of the neighborhood of the rectifier 5; and Fig. 6 is an exploded view of Fig. 5. In Fig. 2, the cover 9 is removed so that the inside construction of the rectifier 5 can be shown in detail.

As shown in Fig. 2 to Fig. 6, the rectifier 5 comprises multiple positive diodes 28 (hereinafter called the diode 28 as needed), positive heat sink 29 on which the positive diodes 28 are mounted (hereinafter called the heat sink 29 as needed), multiple negative diodes 30 (hereinafter called the diode 30 as needed), negative heat sink 31 on which the negative diodes 30 are mounted (hereinafter called the heat sink 31 as needed), and printed circuit board 32 which is a connection part for electrically connecting the diodes 28 and 30 and installed between the two heat sinks 29 and 31. In this embodiment, the negative heat sink 31 is attached with bolts (not shown) to the axial-direction ends of the casing 2 (more exactly, rear casing 2b; see Fig. 3) of the alternator for motor vehicle 1. That is to say, the negative heat sink 31 serves as the heat sink on the casing side and the positive heat sink 29 which, opposed to the negative heat sink 31, is piled with gap on the cooling air inlet side (suction port 15 side) serves as the heat sink on the suction side.

The two heat sinks 29 and 31 made of electrically conductive metal such as aluminum and copper are piled, with a specified gap between them, via the printed circuit board 32 in the axial direction (in the vertical direction in Fig. 3 to Fig. 6), and are connected to each other via insulating bush 33 and screws 34 as shown in Fig. 5 and Fig. 6.

In addition, as shown in Fig. 6, for example, the positive heat sink 29 is provided with multiple portions, which are projected from the mounting surface 29a of the diodes 28 towards both axial directions, along the axial cooling air flow from the suction port 15 (see Fig. 1) and these portions serve as heat sink 35. The heat sink 35 is particularly projected from the mounting surface 29a more in the cooling air inlet side and the height of the projection towards the cooling air inlet side is more than double the thickness of the mounting portion of the corresponding diodes 28, i.e., mounting surface 29a. The heat sink 35 is formed into one piece with the mounting surface 29a by die-casting or pressing. In addition, equally spaced heat sinks 35 are laid out in a radial direction (or in a web shape) and adjacent ones are connected to each other, segmenting the mounting surface 29a of the diodes 28 into multiple areas and surrounding the diodes 28 and 30.

In each area of the mounting surface 29a segmented by the heat sinks 35, multiple diode mounting through-holes 36 are provided for mounting the diodes 28. Each diode 28 is press-fitted into a diode mounting hole 36 with its lead wires 28a directed towards the heat sink 31 and the bottom 28b is exposed to the cooling air flow. With this construction, the cooling air from the suction port 15 directly contacts the bottom 28b of each diode 28.

In addition, multiple suction-side cooling air openings 37 (hereinafter called the cooling air opening 37 as needed) are provided in the mounting surface 29a of the diodes 28 on the heat sink 29. These cooling air openings 37 are provided along the heat sink 35 and through the mounting surface 29a along the cooling air flow, and each heat sink 35 constitutes part or whole periphery of the side wall (inside wall surface) of a cooling air opening 37 provided alongside. In an area segmented by the heat sinks 35 on the mounting surface 29a, the cooling air openings 37 are so arranged as to surround the diode mounting hole 36 and so each diode 28 is surrounded by multiple cooling air openings 37.

Output terminal 38 of the rectifier 5, of which one end is projected out of the cover 9, is press-fitted into the heat sink 29 near the cover 9. In order to supply the direct current output rectified by the rectifier 5 to the outside, that is, vehicle side (electric devices and battery), the connection end (not shown) of the vehicle is electrically connected to the output terminal 38.

On the other hand, on the heat sink 31, there are provided multiple casing-side cooling air openings 39 (hereinafter called the cooling air opening 31 as needed) of which positions axially correspond to those of the cooling air openings 37 or diode mounting holes 36 (in other words, diodes 28) in the mounting surface 29a on the opposed heat sink 29. In addition to these cooling air openings 39, multiple diode mounting through-holes 40 are so provided on the heat sink 31 that each is surrounded by the cooling air openings 39 and also faces the corresponding cooling air opening 37 on the opposed heat sink 29. In this embodiment, as explained above, the cooling air openings 37 and 39 are so provided through the heat sinks 29 and 31 that one side in the stacking direction of the rectifier 5 (rear casing 2b side) can be viewed from the other side (cooling air inlet side) that is separated by the heat sinks 29 and 31 or that the cooling air can be passed almost linearly from one side to the other.

That is to say, the cooling air openings 39 are briefly classified into those of which positions correspond to the diode mounting holes 36 (in other words, diodes 28) of the opposed heat sink 29 in the axial direction (in the flow direction of the cooling air from the suction port 15) and those of which positions correspond to the cooling air openings 37 in the axial direction. It is so designed that the main cooling air flow that has surrounded the diodes 30 and passed through the opposed cooling air openings 37 passes (is transmitted) linearly through the cooling air openings 39 classified as the latter ones. Each diode 30 is press-fitted into a diode mounting hole 40 with its lead wires 30a directed towards the heat sink 29 as shown in Fig. 4 and the bottom 30b is exposed to the cooling air flow. With this construction, the cooling air passing through the gap between the heat sink 31 and rear casing 2a directly contacts the bottom 30b of each diode 30.

In addition, there are provided multiple cooling pins 41 extending towards the cooling air flow direction (almost perpendicularly, that is, in the axial direction in this embodiment) on both axial-direction sides of the heat sink 31. The cooling pins are die-cast into one piece with the heat sink 31. Furthermore, the heat sink 31 is provided on their periphery (outside periphery) with a portion projected towards the opposite side of the cooling air inlet side (that is, rear casing 2b side) and this projected portion constitutes auxiliary heat sink 42. The auxiliary heat sink 42, divided into multiple portions along the periphery in the circumferential direction, is inserted into the exhaust port 13 of the rear casing 2b so as to be positioned in the exhaust flow path as shown in Fig 3.

As shown in Fig. 5 and Fig. 6, each auxiliary heat sink 42 is provided with multiple (four in this embodiment) cooling air openings (cooling air exhaust openings) 42a for exhausting the cooling air (guiding the cooling air to be exhausted). Each cooling air exhaust opening 42a is circumferentially inclined by a specified angle in the radial direction. The outside periphery of the rear casing 2b is opposed to the heat sink 31 with a gap between them, and guide 43 is provided on the outside periphery so as to introduce the cooling air in the radial direction from the outside into the gap between the rear casing 2b and heat sink 31.

On the printed circuit board 32, connection ends 44a to 44c are mounted, for example. The connection ends 44a to 44c are made of electrically conductive low-resistance material such as copper. Of these connection ends, the coil end 16c of the stator winding 16 is connected to the connection end 44a as shown in Fig. 1 so that the alternating current power generated in the stator winding 16 is taken into the printed circuit board 32. In addition, the connection ends 44b and 44c are, for example, connected to the lead wires 28a and 30a extending almost perpendicularly to the heat sinks 29 and 31 (that is, in the axial direction) respectively as shown in Fig. 4, and the connections with the lead wires 28a and 30a are inserted into the cooling air openings 37 and 39 of the opposed heat sinks 29 and 31, respectively and the lead wires are passed through the cooling air openings 37 and 39, respectively. The alternating current power inputted from the stator winding 16 via the connection end 44a is directed to the diodes 28 and 30 via the connection ends 44b and 44c, converted into direct current power, and then outputted to the outside through the output terminal 38.

The heat sinks 29 and 31 are formed together into a contour as explained above (see Fig. 6) by die-cast forming or press forming from a metal plate such as aluminum or copper having specified thickness and high thermal conductivity. The cooling air openings 37 and 39 and diode mounting holes 36 and 40, however, may sometimes be formed by additional pressing or cutting instead of one-piece forming.

Next, the operation of the alternator for motor vehicle according to the embodiment as constructed above is described hereunder.

With the alternator for motor vehicle 1 of this embodiment, each claw-pole rotor 17 is excited when exciting current is received in the exciting winding 18 by way of the brushes 25a and 25b and slip rings 22a and 22b, and then when a rotation drive force is transmitted from the engine (not shown) of the vehicle to the shaft 8 via the pulley 20 and the rotor 6 starts rotating, alternating current power is generated in the stator winding 16 of the stator 3. The alternating current power generated in the stator winding 16 is then rectified by the positive diodes 28 and negative diodes 30 of the rectifier 5, and outputted through the output terminal 38 as direct current drive power and battery storage power for the electric devices installed on the vehicle.

As the fans 19a and 19b installed on the end of the claw-pole rotor 17 start running together with the rotor 4, the outside air is introduced inside, that is, the cooling air flows into the inside of the alternator for motor vehicle 1 through the suction port 10 provided on the front casing 21, suction port 15 provided on the cover 15, and gap between the rear casing 2b and heat sink 29 as partly shown with a broken line in Fig. 1. The cooling air flowing from the front through the inlet port 10 cools the exciting winding 18 and stator winding end 16a and exhausted through one of the exhaust ports 11, 13 and 14. On the other hand, the cooling air flowing from the rear first cools the rectifier 5 and regulator (not shown) and then enters into the rear casing 2b through the cooling air openings 12 and cools the stator winding end 16b, and is finally exhausted from the exhaust port 13 or 14.

The cooling air incoming from the rear of the alternator for motor vehicle 1 classified into one incoming in the axial direction through the suction port 14 provided on the cover 9 and the other incoming in the radial outer direction through the gap between the rear casing 2b and heat sink 29.

The cooling air incoming in the axial direction through the suction port 15 is first directed in the axial direction along the heat sink 35. Part of this flow, while contacting the bottom 28b of the diodes 28 and cooling the diodes 28 directly, flows in the radial direction along the mounting surface 29a of the rectifier as shown in Fig. 4. Then, as it passes through the cooling air openings 37, it cools the lead wires 30a of the diodes 30 and connection ends 44c thereof. It further flows into the cooling air openings 39 linearly and cools the lead wires 28a of the diodes 28 and connection ends 44b thereof, and then enters into the rear casing 2b through the cooling air openings 12.

As shown in Fig. 3 and Fig. 4, another part of the cooling air flow from the suction port 15 passes through the cooling air openings 37 and 39 linearly and/or passes through the cooling air openings 37 and cools the lead wires 30a of the diodes 30 and connection ends 44c thereof, and then passes through the cooling air openings 39. It finally enters into the gap between the rear casing 2b and heat sink 31 and contacts the bottom 30b of the diodes 30 directly and cools the diodes 30, and then enters into the rear casing 2b through the cooling air openings 12.

In addition, another part of the cooling air flow from the suction port 15 contacts the cooling pins 41 of the heat sink 31 and cools the heat sink 31 before it enters into the rear casing 2b.

On the other hand, part of the cooling air flow incoming in the radial outer direction through the gap between the rear casing 2b and heat sink 29 enters directly into the gap between the heat sinks 29 and 31 and meets with the cooling air flow from the suction port 15 as shown in Fig. 3, and they together cool the diodes 28 and 30 as needed and enter into the rear casing 2b.

Another part of the cooling air flow incoming through the gap between the rear casing 2b and heat sink 29, directed by the guide 43 installed on the rear casing 2b, enters into the gap between the heat sink 31 and rear casing 2b and meets with the cooling air flow from the suction port 15, and they together cool the diodes 30 and enter into the rear casing 2b.

Each cooling air flow incoming through the suction port 15 or the gap between the rear casing 2b and positive heat sink 29 and finally entering into the rear casing 2b cools the coil ends 16b of the stator winding and then exhausted out of the rear casing 2b through the exhaust port 13 or exhaust port 14. Part of the cooling air flow passing through the exhaust port 13 cools the auxiliary heat sink 42 as it passes through each cooling air exhaust opening 42a of the auxiliary heat sink 42 provided on the heat sink 31.

Effects to be produced from the embodiment of the present invention are described one after another hereunder.

### (1) Effects of providing the cooling air openings 37 and 39

In this embodiment, because the cooling air openings 37 and 39 provided on the heat sinks 29 and 31 are so positioned as to correspond to each other in the axial direction and allow the cooling air to pass through, the flow path resistance of the cooling air can be decreased and so smooth cooling air flow can be realized. In addition, the diodes 28 and 30 are surrounded by multiple cooling air openings 37 and 39 and furthermore they themselves face the opposite cooling air openings 37 and 39. With this construction, because the cooling air can be linearly directed onto the diodes 28 and 30, which are typical heat generating members, and be made in effective and direct contact with the diodes 28 and 30, cooling effect can be drastically enhanced.

### (2) Effect of the shape of the heat sink 35

The diodes 28 are surrounded by the multiple cooling air openings 37 and furthermore the cooling air openings 37 themselves are surrounded by the heat sinks 35. With this construction, the diodes 28 can receive extremely favorable cooling effect because of not only direct cooling effect by the cooling air flowing around them smoothly but also efficient heat radiation through the adjacent heat sinks 35.

In addition, since the heat sinks 35 is ensured to have sufficient height (more than double) as compared to the thickness of the rectifier mounting surface 29a, they have sufficient specific surface area. Furthermore, because multiple cooling air openings 37 are provided along the heat sinks 35 and accordingly the cooling air flows smoothly along the heat sinks 35, the heat radiation characteristic synergized by the wide specific surface area improves drastically. Having sufficient height in the axial direction (in the cooling air flow direction) allows the cooling air to be smoothly guided by the heat sinks 35, and accordingly the cooling air flow is further smoothened. Thus, the diodes 28 adjacent to the heat sinks 35 can be efficiently cooled down.

In particular, in the present embodiment, because the heat sink 29 on the cooling air inlet side is made positive, the positive diodes 28 that generates more heat than the negative ones can be actively cooled, and hence the overall heat radiation can be well balanced and the rectifier 5 can be cooled down evenly.

Furthermore, because the adjacent heat sinks 35 are so connected with each other as to be provided in a radial layout from the inside periphery to the outside, a rib effect can be produced, which in turn contributes to improve the mechanical strength of the heat sink 29. Since the heat sinks 25 are formed in a radial layout and provided uniformly over the heat sink 29, the heat radiation from the heat sink 29 itself can be equalized and accordingly the temperature different from place to place can be decreased. Furthermore, since the heat sinks 35 are uniformly provided, the cooling air openings 37 provided between the heat sinks 35 can be well-balanced in terms of position. Thus, the cooling air can be uniformly supplied onto the heat sink 31, which in turn contributes to decrease the temperature difference on the heat sink 31.

Since the heat sinks 35 are formed into one piece with the heat sink 29 by die-casting or the like, the productivity can improves and accordingly the alternator for motor vehicle 1 can be offered at a lower cost.

### (3) Effects of the layout of the lead wires 28a and 30a

The connection ends 44b and 44c of the printed circuit board 32 together with the lead wires 28a and 30a connected with them respectively are so inserted into the cooling air openings 37 and 39 as to be positioned in the parallel direction to the cooling air flow. In particular since the connection ends 44b and 44c are made of copper with high electrical conductivity and since the cooling air is made to contact the connection ends 44b and 44c directly, heat generated from the diodes 28 and 30 is transmitted to the connection ends 44b and 44c via the lead wires 28a and 30a and hence the heat from the diodes 28 and 30 can be removed efficiently. In other words, by laying out the connection terminals 44b and 44c and lead wires 28a and 30a as above, they can be served as something like cooling pin.

### (4) Effects of providing the guide 43

With a construction where the cooling air is introduced into the gap between the heat sink 31 and rear casing 2b by way of the guide 43, the cooling air volume for cooling the bottom 30b of the diodes 30 can be increased. Although the heat sink 31 is not favorable for securing the heat radiation performance because it is located far from the cooling air inlet (suction port 15) as compared to the heat sink 29, sufficient cooling performance can be secured for the diodes 30 located in the downstream of the cooling air flow by introducing the cooling air directly in the radial outer direction and directing part of the air flow into the narrow gap between the heat sink 31 and rear casing 2b with the aid of the guide 43.

### (5) Effects of providing the cooling pins 41

Since the cooling air flow in each route is branched or jointed at the gap between the heat sinks 29 and 31 and/or in the distance from the heat sink 31 to the cooling air openings 12 of the rear casing 2b, the flow is relatively jammed there as shown in Fig. 3 and Fig. 4. By providing the non-directive cooling pins 41 on both sides of the heat sink 31 so as to face the cooling air flow at relevant positions, the cooling air flow can cover the whole areas and also sufficient contact time of the cooling air with the heat sinks 29 and 31 and rear casing 2b can be secured. In addition, because of the heat radiation effect of the cooling pins 41 themselves, the cooling efficiency (heat radiation performance) can be drastically enhanced.

Since the cooling pins 41 are formed into one piece with the heat sink 31 by die-casting or the like, thin cooling pins 41 can be surely provided in a narrow space. Thus, the gap between the heat sinks 29 and 31 and the gap between the heat sink 31 and rear casing 2b, both of which are normally left as dead space, can also be utilized effectively. Furthermore, die-casting the cooling pins 41 can improve the productivity and accordingly the alternator for motor vehicle can be offered at a lower cost.

### (6) Effects of providing the auxiliary heat sink 42

Since the heat sink 31 is located farther from the suction port 15 than the heat sink 29 as explained above, the heat sink 31 is less favorable than the heat sink 29 in terms of heat radiation performance. To the contrary, in this embodiment, the auxiliary heat sink 42 extending towards the rear casing 2b side is provided along the periphery of the heat sink 31 located far from the suction port 15 and it is subjected to the cooling air flow having the highest flow speed that is discharged from the rear casing 2b by the fan 19b. With this construction, since the heat radiation from the heat sink 31 can be assisted and accelerated, the cooling efficiency (heat radiation performance) of the heat sink 31 can be drastically enhanced and the difference from the heat sink 29 in the heat radiation performance can be corrected. That is to say, disadvantage of the heat sink 31 in terms of heat radiation performance due to being located far from the suction port 15 can be overcome, and accordingly the diodes 30 can be cooled down to the same extent as the diodes 28.

Since the exhaust port 13 is so formed as to leave a gap against the auxiliary heat sink 42 as shown in Fig. 3, and accordingly the auxiliary heat sink 42 does not get in direct contact with the rear casing 2b, decrease of the cooling performance due to the thermal effect from the stator winding 16 can hardly be caused.

In addition, since the cooling air exhaust openings 42a of the auxiliary heat sink 42 is uniformly declined in the radial direction as shown in Fig. 5 and Fig. 6, the cooling air flow is rectified along a spiral direction as it passes through the cooling air exhaust openings 42a, and accordingly the cooling air exhaust from the exhaust port 13 can be smoothened and hence noise from the fan can be reduced.

According to the present embodiment, as explained above, the cooling air can be made to contact efficiently and uniformly with the rectifier 5, heat generating members, including the diodes 28 and 30 above all, and stator winding 35, exciting winding 32 and regulator as well, and heat sinks 29 and 31 that promote heat radiation from the diodes 28 and 30, the cooling performance of the heat generating members can be improved drastically. Accordingly, it becomes possible to increase the output of the alternator for motor vehicle and also to build it in more compact design.

Although the positive diodes 28 are arranged on a heat sink located closer to the suction port 15 in this embodiment, the arrangement is not limited to the above but it is also permissible that the negative diodes 30 are arranged on a heat sink closer to the suction port 15. Similar effects can be produced from this arrangement.

According to the present invention, because the cooling air can be directed effectively onto the heat generating members such as rectifier and heat sink for them, cooling performance can be drastically enhanced, and accordingly alternator for motor vehicle can produce far higher output and be made in more compact design.

## Claims

1. Alternator for motor vehicle comprising a stator (3), a rotor (4) installed inside the stator (3) allowing for a rotation clearance, and a rectifier (5), installed in the cooling air flow introduced from the outside into the inside, for rectifying the power produced in the stator (3); wherein
the rectifier (5) is made of a heat sink (29) equipped with positive diodes (28) and heat sink (31) equipped with negative diodes (30) respectively, stacked one over the other, and both diodes (28, 30) are connected electrically;
the heat sinks (29, 31) are provided with multiple through cooling air openings (37, 39) around the corresponding diodes (28, 30) respectively; and
the heat sink (29) installed at the inlet side of the cooling air is provided with portions projected from the mounting surface (29a) of the diodes (28) towards the cooling air inlet side, surrounding the corresponding diodes (28, 30).

2. Alternator for motor vehicle according to Claim 1, wherein the cooling air openings (37, 39) are so formed that one side in the stacking direction of the rectifier (5) can be viewed from the separate other side or that the cooling air can be passed through substantially linearly.

3. Alternator for motor vehicle according to Claim 1 or 2, wherein the projected portions are walls and the height is more than double the thickness of the mounting portion of the corresponding diodes.

4. Alternator for motor vehicle according to at least one of Claims 1 to 3, wherein the heat sink (29) installed on the cooling air inlet side is the heat sink equipped with the positive diodes (28).

5. Alternator for motor vehicle according to at least one of Claims 1 to 4, wherein, the heat sink (31) installed on the opposite side of the cooling air inlet side is the heat sink equipped with the negative diodes (30).

6. Alternator for motor vehicle according to at least one of Claims 1 to 5, wherein a connection member (32) for electrically connecting between the diodes (28, 30) is installed between the heat sinks (28, 30).

7. Alternator for motor vehicle according to at least one of Claims 1 to 6, wherein the connection between the positive diodes (28) and the connection member (32) is inserted into each cooling air opening (39) of the heat sink (31) equipped with the negative diodes (30).

8. Alternator for motor vehicle according to at least one of Claims 1 to 7, wherein the connection between the negative diodes (30) and the connection member (32) is inserted into each cooling air opening (37) of the heat sink (29) equipped with the positive diodes (28).

9. Alternator for motor vehicle according to at least one of Claims 1 to 8, wherein, the heat sink (31) installed on the opposite side of the cooling air inlet side is provided with portions projected towards the opposite side of the cooling air inlet side.

10. Alternator for motor vehicle according to at least one of Claims 1 to 9, wherein the projected portions are auxiliary heat sink (42) extending towards the opposite side of the cooling air inlet side and are provided around the periphery of the heat sink (31) installed on the opposite side of the cooling air inlet side.

11. Alternator for motor vehicle according to at least one of Claims 1 to 10, wherein the auxiliary heat sink (42) is divided into multiple portions along the periphery and provided on the periphery.

12. Alternator for motor vehicle according to at least one of Claims 1 to 11, wherein the auxiliary heat sink (42) is inserted into the cutout provided in the casing (2) that supports the stator (2).

13. Alternator for motor vehicle according to at least one of Claims 1 to 12, wherein the auxiliary heat sink (42) is equipped with cooling air openings (42a).

14. Alternator for motor vehicle according to at least one of Claims 1 to 13, wherein, the heat sink (31) installed on the opposite side of the cooling air inlet side is equipped with multiple cooling pins (41) extending towards the cooling air flow direction.

15. Alternator for motor vehicle according to at least one of Claims 1 to 14, wherein the multiple cooling pins (41) are formed into one piece with the heat sink (31) installed on the opposite side of the cooling air inlet side.

16. Alternator for motor vehicle, which generates power by rotating a rotor (4), comprising
casing (2) inside of which the rotor (4) is installed;
casing-side heat sink (31) mounted on the axial direction end of the casing (2);
suction-side heat sink (29) stacked on the cooling air inlet side, facing the casing-side heat sink (31);
multiple diodes (28, 30) mounted on the suction-side heat sink (29) and casing-side heat sink (31) respectively;
printed circuit board (32) equipped with multiple connection ends for connecting with the lead wires of the diodes (28, 30) and installed between the casing-side heat sink (31) and suction-side heat sink (29);
heat sink (35) so provided as to project towards the cooling air inlet side from the mounting surface (29a) of the diodes (28) on the suction-side heat sink (29), surrounding the diodes (28); and
multiple cooling air openings (37, 39) so provided around the diodes (28, 30) on the suction-side heat sink (29) and casing-side heat sink (31) as to allow the cooling air to pass through.

17. Alternator for motor vehicle according to Claim 16, wherein the heat sink (35) is formed into one piece with the mounting surface (29a), constituting part of the inside wall of the cooling air openings, and the projected height is more than double the thickness of the mounting surface (29a).

18. Alternator for motor vehicle according to Claim 16 or 17, wherein the diodes (28) mounted on the suction-side heat sink (29) are positive diodes.

19. Alternator for motor vehicle according to at least one of Claims 16 to 18, wherein the connection between the lead wires of the diodes (28) mounted on the suction-side heat sink (29) and the connection ends of the printed circuit board (32) are passed through the cooling air openings (39) provided on the casing-side heat sink (31).

20. Alternator for motor vehicle according to at least one of Claims 16 to 19, wherein diode mounting through-holes (36, 40) are provided on the mounting surface and the bottom of the diode press-fitted into the diode mounting hole is exposed to the cooling air flow.

21. Alternator for motor vehicle according to at least one of Claims 16 to 20, wherein there is provided an auxiliary heat sink (42) extending towards the casing (2) installed on the periphery of the casing-side heat sink (31).

22. Alternator for motor vehicle according to at least one of Claims 16 to 21, wherein the auxiliary heat sink (42) is divided in the circumferential direction and inserted into the cooling air exhaust port cut out in the casing (2).

23. Alternator for motor vehicle according to at least one of Claims 16 to 22, wherein the auxiliary heat sink (42) is provided with cooling air exhaust openings for exhausting the cooling air.

24. Alternator for motor vehicle according to at least one of Claims 16 to 23, wherein the cooling air exhaust openings are circumferentially inclined in the radial direction.

25. Alternator for motor vehicle according to at least one of Claims 16 to 24, wherein
the connection between the lead wires of the diodes (30) mounted on the casing-side heat sink (31) and the connection ends of the printed circuit board (32) are passed through the cooling air openings (37) provided on the suction-side heat sink (29).

26. Alternator for motor vehicle according to at least one of Claims 16 to 25, wherein the casing-side heat sink (31) is provided with multiple cooling pins (41) extending in the axial direction.

27. Alternator for motor vehicle according to at least one of Claims 16 to 26, wherein the cooling pins (41) are formed into one piece with the casing-side heat sink (31).

28. Alternator for motor vehicle according to at least one of Claims 16 to 27, wherein a guide (43) is provided for introducing the cooling air in the radial direction from the outside into the gap between the casing-side heat sink (31) and casing (2).

29. Alternator for motor vehicle which generates power by rotating a rotor (4), wherein on the two heat sinks (29, 31) installed in the casing (2) and opposed to each other, there are provided multiple cooling air openings (37, 39) of which positions axially correspond one to the other in the parallel direction of the cooling air flow, and diodes (28, 30) are mounted on the two heat sinks (29, 31), being surrounded by these cooling air openings (37, 39); and
on the heat sink (29) closer to the cooling air suction port (15), there are provided heat sinks (35) projected towards the cooling air inlet side, surrounding in layers the cooling air opening.
